# FASCICULE DE BREVET EUROPEEN

(11) **EP 3 182 586 B1**
(45) Date de publication et mention de la délivrance du brevet: **20.05.2020**
(21) Numéro de dépôt: 16203637.0
(22) Date de dépôt: 13.12.2016
(51) Int. Cl.: H03F 3/26

(54) **AMPLIFICATEUR DE PUISSANCE RF A DOUBLE TRANSISTORS ET POSTE RF UTILISANT UN TEL AMPLIFICATEUR**
FUNKFREQUENZ-LEISTUNGSVERSTÄRKER MIT DOPPELTRANSISTOREN UND FUNKFREQUENZSTELLE, DIE EINEN SOLCHEN VERSTÄRKER VERWENDET
RF POWER AMPLIFIER WITH DUAL TRANSISTORS AND RF STATION USING SUCH AN AMPLIFIER

(30) Priorité: 18.12.2015 FR 1502638
(43) Date de publication de la demande: 21.06.2017
(73) Titulaire: Thales, 92400 Courbevoie (FR)
(72) Inventeur: DEMENITROUX, Wilfried, 49300 Cholet (FR); AUGEREAU, Hughes, 49300 Cholet (FR); SABOUREAU, Cedrick, 49300 Cholet (FR)
(74) Mandataire: Lucas, Laurent Jacques

(56) Documents cités:
- US-A1- 2012 062 322
- SHUK-FUN LAI ET AL: "Quiescent current control for low distortion linear power amplifier", 2013 IEEE INTERNATIONAL CONFERENCE OF IEEE REGION 10 (TENCON 2013), IEEE, 1 novembre 2015 (2015-11-01), pages 1-3, XP032845174, ISSN: 2159-3442, DOI: 10.1109/TENCON.2015.7373062 ISBN: 978-1-4799-2825-5 [extrait le 2016-01-05]
- DEMENITROUX W ET AL: "Wideband high power high efficiency linear GaN power amplifier for cognitive radio application", 2014 9TH EUROPEAN MICROWAVE INTEGRATED CIRCUIT CONFERENCE, EUROPEAN MICROWAVE ASSOCIATION - EUMA, 6 octobre 2014 (2014-10-06), pages 620-623, XP032712506, DOI: 10.1109/EUMIC.2014.6997933

## Description

La présente invention concerne un amplificateur de puissance RF à double transistor, conservant ses propriétés linéaires en modulation sur une large gamme de puissances.

Elle concerne également un système d'émission et de réception RF comportant un tel amplificateur.

L'invention s'applique pour tous types de poste RF, notamment les postes portatifs.

Dans les systèmes d'émission RF, il est connu que les amplificateurs de puissance sont sujets au phénomène de saturation de la puissance de sortie pour de fortes puissances d'entrée. A cause du comportement non linéaire ainsi produit, on observe une distorsion harmonique. Plus particulièrement, on observe l'apparition de « fréquences parasites » qui sont des combinaisons linéaires des fréquences composant le signal à amplifier. Ce type de défaut est très gênant pour les amplificateurs traitant de signaux radioélectriques, car ces fréquences parasites peuvent perturber les liaisons RF.

Les effets d'un comportement non linéaire, de non-linéarité, apparaissent donc lorsqu'on augmente la puissance de fonctionnement des amplificateurs. Pour des modulations numériques de signaux à forte amplitude (fort « Peak to average »), les amplificateurs ne peuvent alors pas être utilisés à leur maximum de puissance, afin de préserver leur propriété de linéarité. Il en résulte donc une perte de rendement.

D'un autre côté, la classe de l'amplificateur étant fixée, deux types de fonctionnement sont disponibles.

Si on souhaite utiliser l'amplificateur à bas niveau de puissance avec une grande linéarité on doit utiliser une classe dite « A » très linéaire à bas niveau mais qui sature plus rapidement en puissance, donc beaucoup moins linéaire à fort niveau ;

Si on souhaite utiliser l'amplificateur à fort niveau de puissance, on doit utiliser une classe dite « AB » qui permet une stauration moins rapide en puissance et donc une linéarité meilleure à fort niveau, cependant à bas niveau la linéarité est fortement dégradée. On ne peut donc pas utiliser l'amplificateur avec son maximum de linéarité sur une large gamme de puissance.

Une solution connue pour tenir les performances de linéarité est d'appliquer une pré-distorsion numérique, également connue comme technique DPD. Cependant cette solution est volumineuse car la mise en œuvre de la DPD nécessite l'ajout de matériel. Elle est aussi complexe à utiliser car elle implique des asservissements et des gestions de retard RF notamment. Ces contraintes font qu'elle est également coûteuse.

Un document de SHUK-FUN et al : « Quiescent current control for low distorsion linear power amplifier », 2013 IEEE INTERNATIONAL CONFERENCE OF IEEE REGION 10, IEEE, 1 novembre 2015, pages 1-3 divulgue un amplificateur de puissance RF à double transistors. De même un document US 2012/062322 A1 divulgue un tel amplificateur.

Un but de l'invention est notamment de pallier les inconvénients précités, en permettant notamment une tenue des performances de linéarité des amplificateurs de puissance en classe AB sur toute modulation numérique et dans une large gamme de puissance, pouvant atteindre par exemple 25 dB en sortie, et cela avec une simplicité de mise en oeuvre.

A cet effet, l'invention a pour objet un amplificateur de puissance RF selon la revendication 1.

Les valeurs desdites tensions de grille sont par exemple fonction de la fréquence, de la puissance de sortie dudit amplificateur ou de la température.

Lesdites valeurs des tensions de grille sont par exemple déterminées dans une phase de calibrage où, des critères de linéarité dudit amplificateur étant fixés à l'avance, les couples retenus sont ceux qui répondent auxdits critères.

La tenue auxdits critères est par exemple vérifiée à l'aide de mesures d'EVM ou à l'aide de mesures d'AM/AM et AM/PM.

L'invention a également pour objet un poste d'émission et de réception RF utilisant un tel amplificateur tel que décrit précédemment, ce poste étant par exemple portable.

D'autres caractéristiques et avantages de l'invention apparaîtront à l'aide de la description qui suit, faite en regard de dessins annexés qui représentent :
- La figure 1, un schéma d'un amplificateur de puissance RF à double transistors selon l'art antérieur ;
- La figure 2, un schéma d'un amplificateur de puissance RF à double transistors selon l'invention ;
- La figure 3, une illustration de l'amélioration du compromis entre puissance et linéarité apportée par l'invention.

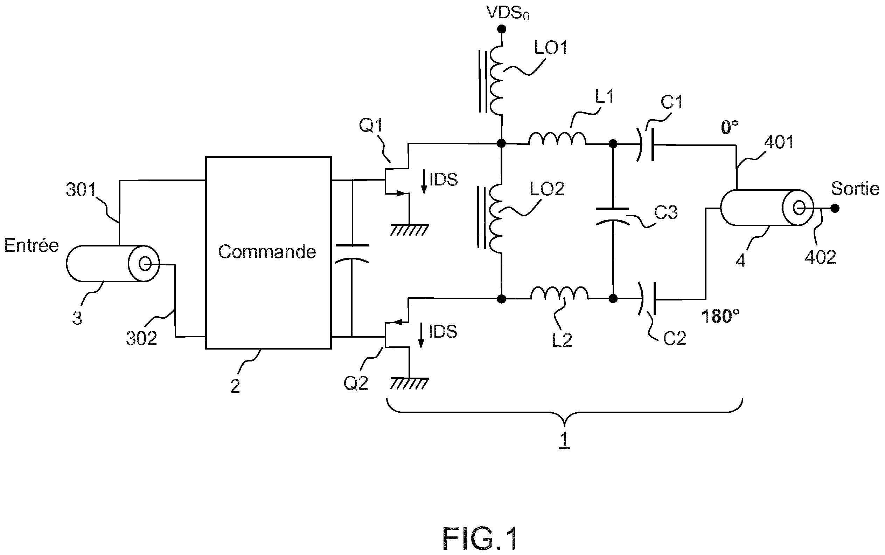

La figure 1 présente le schéma d'un amplificateur de puissance RF à double transistors. Elle présente plus particulièrement l'étage de sortie 1 d'un amplificateur de puissance comportant deux transistors Q1, Q2 montés pour être commandés en push-pull, les transistors de préférence étant à effet de champ (FET).

Un amplificateur de puissance comporte généralement plusieurs étages, un étage d'entrée, un étage de commande 2 et l'étage de sortie 1, ce dernier fournissant la puissance. L'étage de commande est également représenté en figure 1 par un bloc 2, il est réalisé de façon classique et bien connue par ailleurs.

Par cet étage de commande, les deux transistors sont commandés en push-pull. Un premier transistor Q1 est commandé à l'état passant une demi-période sur deux, le deuxième transistor Q2 étant commandé à l'état passant l'autre demi-période. Un même courant de repos, drain-source, IDS parcourt les deux transistors. Les deux transistors présentent ainsi un fonctionnement symétrique. Ces transistors Q1, Q2 sont commandés à l'ouverture par leur tensions de grille respectives V_{GS1}, V_{GS2} délivrées par l'étage de commande 2.

Ce type de montage en push-pull est utilisé classiquement dans les amplificateurs RF selon l'art antérieur.

Le signal RF d'entrée est conduit par une ligne RF 3, du type coaxial par exemple, la composante du signal RF porté par un conducteur 301 active la tension de grille V_{GS1} via l'étage de commande alors que la composante porté par l'autre conducteur 302 active la tension de grille V_{GS2}. Le signal RF portée par ces conducteurs est amplifié par les transistors Q1, Q2 alimentés classiquement par une source de puissance de tension VDS₀ via des bobines d'inductions L₀₁, L₀₂ couplées.

L'étage de sortie 1 de l'amplificateur, également étage de puissance comporte, en sortie des transistors, un réseau à base d'inductances et de capacités. Ainsi le transistor Q1 est relié à un conducteur 401 de la ligne RF de sortie 4 via une inductance L₁ et une capacité C₁, et le transistor Q2 est relié à un conducteur 402 de la ligne RF de sortie 4 via une inductance L₂ et une capacité C₂, les deux lignes étant découplées par une capacité C₃.

Comme il a été précédemment décrit, ce type d'amplificateur à transistors montés en push-pull ne peut fonctionner de façon linéaire sur une large gamme de puissance. Les fortes puissances entraînent des comportements non-linéaires qui eux-mêmes provoquent des distorsions harmoniques dégradant les radiocommunications. Plus précisément, de façon connue, le comportement non-linéaire des amplificateurs de puissance génère des distorsions de phase et d'amplitude sur les signaux émis. Ces distorsions engendrent des remontées spectrales en dehors de la bande du signal utile et déforment les constellations des signaux modulés.

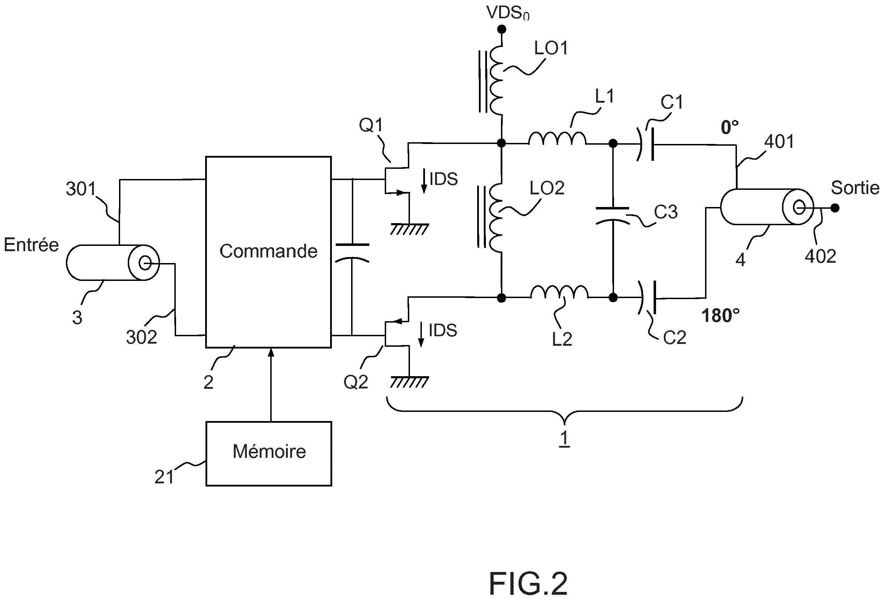

La figure 2 présente un exemple de réalisation d'un amplificateur de puissance RF selon l'invention. Il comporte la même structure ou architecture que celui de la figure 1 mais son fonctionnement en push-pull est dissymétrique.

Plus particulièrement, les transistors Q1, Q2 fonctionnent toujours selon une commande du type push-pull mais leurs polarisations sont rendues dissymétriques. En d'autres termes, alors que dans un amplificateur classique le courant IDS parcourant les deux transistors est le même, dans un amplificateur selon l'invention, le premier transistor Q1 est parcouru par un premier courant IDS1 et le deuxième transistor Q2 est parcouru par un deuxième courant IDS2, ces deux courants étant différents.

En rendant ainsi les polarisations des transistors dissymétriques, l'invention permet de compenser le phénomène d'auto polarisation de ces transistors, phénomène qui cause les non-linéarités.

Pour permettre cette dissymétrie, c'est-à-dire des courants drain-source ID1 et IDS2 différents, la commande doit être modifiée par rapport à un amplificateur classique du type de la figure 2, en particulier au niveau de la valeur des tensions de grille V_{GS1}, V_{GS2}. En particulier, il faut pouvoir commander les amplitudes de ces tensions de façon indépendante.

Les tests et essais réalisés par la Déposante ont montré qu'en rendant les polarisations dissymétriques, les fonctions de transfert dites « AM/AM » (Amplitude/Amplitude) et « AM/PM » (Amplitude/Phase) sont améliorées à niveau de puissance moyen, permettant d'améliorer grandement les résultats d'EVM et d'ACPR associés caractérisant la linéarité de l'amplificateur.

La non-linéarité des amplificateurs de puissance provoquant des distorsions de phase et d'amplitude sur les signaux émis comme précisé ci-dessus, engendrant des remontées spectrales en dehors de la bande utile et déformant les constellations des signaux modulées, on rappelle que ces distorsions sont notamment caractérisés par :
- l'APCR (Adjacent Channel Power Ration) représentant le rapport entre la puissance du signal dans la bande utile et la puissance du signal généré par les distorsions dans un canal adjacent, représentant en d'autres termes le rapport de puissance entre le spectre voulu et spectre non voulu ;
- l'EVM (Error Vector Magnitude) représente la distance moyenne entre les points de la constellation idéale et les valeurs des échantillons reçus soumis aux distorsions de l'amplificateur.

Les valeurs de tensions de grille V_{G1}, V_{G2}, déterminant le couple IDS1, IDS2, sont définies afin d'obtenir les conditions de linéarité souhaitées. Elles peuvent être ajustées en fonction de la fréquence d'émission. On peut alors mémoriser un tableau donnant les valeurs du couple (V_{G1}, V_{G2}) en fonction de la fréquence. Ce tableau est accessible à l'étage de commande 2 qui délivre les tensions de grille V_{G1}, V_{G2}.

Ce couple de polarisation dissymétrique, (V_{G1}, V_{G2}), peut être déterminé à l'aide d'une mesure d'EVM ou à l'aide de mesures d'AM/AM et AM/PM. Une fois ce couple déterminé pour un amplificateur prototype, il peut être appliqué sur tous les autres amplificateurs. Plus précisément, les différentes valeurs déterminées en fonction de la fréquence d'émission peuvent appliquées.

La détermination des couples de polarisation dissymétrique correspond donc à une phase de calibrage dans laquelle on effectue les mesures d'EVM ou d'AM/AM et AM/PM de l'amplificateur de puissance en fonction de différentes valeurs de courants IDS1 et IDS2, c'est-à-dire de couple (V_{G1}, V_{G2}) selon les différentes fréquences d'émission. Pour chaque fréquence, la valeur du couple donnant la meilleure linéarité est retenue et stockée dans une table. La bande de fréquences utile est échantillonnée pour obtenir un jeu de fréquences représentatives pour lesquelles sont déterminés les couples. Cette table peut être stockée sur le circuit sur lequel est implanté l'amplificateur de puissance. En fonction de la fréquence, l'étage de commande de l'amplificateur récupère les valeurs de tensions V_{G1}, V_{G2} à appliquer sur les transistors Q1, Q2 montés en push-pull.

En pratique, la présente invention peut être mise en œuvre très simplement. Lors de la phase de mise au point et de calibrage, on alimente séparément et indépendamment les tensions de grille V_{G1}, V_{G2}, donc d'entrée, de chaque transistor Q1, Q2 constituant l'amplificateur push-pull.

Lors de cette phase de mise au point et de calibrage, les valeurs des tensions continues de grille, donc d'entrée de l'amplificateur push-pull, sont balayées, contrôlées et mesurées de façon séparées. Le balayage des valeurs sur une plage donnée permet de tomber sur les valeurs donnant les meilleurs résultats en ce qui concerne la linéarité de l'amplificateur, cette linéarité étant notamment caractérisée par les mesures d'EVM ou d'AM/AM et AM/PM.

Une mesure de linéarité est donc couplée au balayage des valeurs de tensions de grille suivant par exemple deux procédures différentes :
- à l'aide d'une mesure d'EVM, avec par exemple un générateur de signaux modulés et un analyseur de signaux modulés ;
- ou à l'aide de mesures d'AM/AM et AM/PM, avec par exemple un analyseur de réseau vectoriel.

Une fois ces couples de valeurs de tensions continues de grille déterminés selon des critères de linéarité fixés à l'avance, ces valeurs de tension sont stockées dans une mémoire 21 accessible directement par l'amplificateur en configuration push-pull. Ces valeurs peuvent être stockées sous forme de table ou de loi polynomiale. Comme il a été précisé précédemment, ces valeurs dépendent de la fréquence. Elles peuvent également être déterminées en fonction du niveau de puissance et du niveau de température. On obtient alors une table à plusieurs entrées ou une loi polynomiale à plusieurs variables.

Lors du fonctionnement d'un amplificateur, les valeurs de tensions de grille continues déterminées lors de la phase de calibrage sont appliquées suivant, par exemple, la fréquence, la puissance et la température d'utilisation de cet amplificateur dans l'équipement final, un système d'émission et de réception RF portatif notamment. Le comportement linéaire de l'amplificateur est ainsi amélioré par compensation du phénomène d'auto-polarisation des transistors.

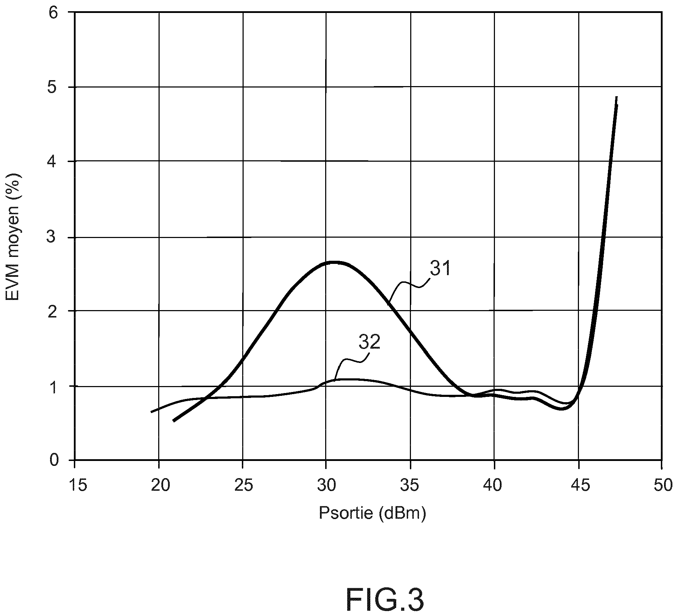

La figure 3 illustre le gain de linéarité obtenu avec un amplificateur de puissance selon l'invention. Cette figure représente par deux courbes 31, 32 l'évolution de mesures d'EVM en fonction de la puissance de sortie, exprimée en dB, pour une fréquence donnée égale à 30 MHz.

Une première courbe 31 représente les mesures d'EVM pour un amplificateur de type push-pull selon l'art antérieur avec une polarisation classique des transistors. Une remontée de la courbe 31 à moyen niveau de puissance caractérise les non-linéarités.

La deuxième courbe 32 représente les mesures d'EVM, pour un amplificateur selon l'invention, obtenues en rendant dissymétrique les courants de repos IDS1, IDS2 (tensions continues de grille différentes). Pour cet amplificateur, la remontée de courbe à moyen niveau de puissance a disparu. Le comportement linéaire de l'amplificateur est donc amélioré.

L'invention permet de résoudre le ou les problèmes posés. En particulier, elle améliore les performances de linéarité pour les puissances faibles sans dégradation des performances à fortes puissances.

Cette amélioration s'obtient à coût réduit, en particulier dû au fait qu'un seul réglage est nécessaire, effectué pour un seul amplificateur prototype lors de la phase de calibrage.

L'invention présente par ailleurs plusieurs avantages.

En particulier, elle peut être très facilement mise en œuvre. Il suffit juste de prévoir un réglage séparé du courant de repos des deux transistors de l'amplificateur montés en push-pull. Ce réglage est réalisé facilement à partir d'une mémoire contenant les valeurs de tensions de grille à appliquer sur chacun des transistors en fonction de divers paramètres, dont notamment la fréquence d'utilisation, la puissance ou encore la température, d'autres paramètres pouvant être pris en compte.

L'invention permet de faciliter la tenue des spécifications d'EVM sur les postes de radiocommunication logicielle.

Elle permet également une bonne reproductibilité des performances grâce notamment aux valeurs de couples de tensions de grille à appliquer mémorisés et destinés aux différents amplificateurs.

## Revendications

1. Amplificateur de puissance RF à double transistors, lesdits transistors (Q1, Q2) étant des transistors à effet de champs commandés en push-pull, lesdits transistors étant configurés pour fonctionner de manière dissymétrique signifiant que les courants drain-source (IDS1, IDS2) desdits transistors à l'état passant sont différents, lesdits courants étant commandés par les tensions de grille (V_{G1}, V_{G2}) desdits transistors (Q1, Q2), **caractérisé en ce que**
lesdits courants sont commandés par un étage de commande (2) de façon indépendante, et les valeurs desdites tensions étant fonctions de paramètres de fonctionnement, ledit amplificateur comportant une mémoire (21) stockant les couples desdites valeurs fonctions desdits paramètres, la mémoire étant accessible audit étage de commande.

2. Amplificateur de puissance selon la revendication 1, **caractérisé en ce que** les valeurs desdites tensions de grille (V_{G1}, V_{G2}) sont fonction de la fréquence.

3. Amplificateur de puissance selon l'une quelconque des revendications précédentes, **caractérisé en ce que** les valeurs desdites tensions de grille (V_{G1}, V_{G2}) sont fonction de la puissance de sortie dudit amplificateur.

4. Amplificateur de puissance selon l'une quelconque des revendications précédentes, **caractérisé en ce que** les valeurs desdites tensions de grille (V_{G1}, V_{G2}) sont fonction de la température.

5. Amplificateur de puissance selon l'une quelconque des revendications précédentes, **caractérisé en ce que** lesdites valeurs des tensions de grille (V_{G1}, V_{G2}) sont déterminées dans une phase de calibrage où, des critères de linéarité dudit amplificateur étant fixés à l'avance, les couples retenus sont ceux qui répondent auxdits critères.

6. Amplificateur de puissance selon la revendication 5, **caractérisé en ce que** la tenue auxdits critères est vérifiée à l'aide de mesures d'EVM.

7. Amplificateur de puissance selon les revendications 5 ou 6, **caractérisé en ce que** la tenue auxdits critères est vérifiée à l'aide de mesures d'AM/AM et AM/PM.

8. Système d'émission et de réception RF, **caractérisé en ce qu'**il comporte un amplificateur de puissance selon l'une quelconque des revendications précédentes.

9. Système d'émission et de réception RF selon la revendication 8, **caractérisé en ce qu'**il est portable.

## Patentansprüche

1. Funkfrequenz-Leistungsverstärker mit Doppeltransistoren, wobei die Transistoren (Q1, Q2) Transistoren mit Feldeffekt sind, welche im Push-Pull-Modus gesteuert werden, wobei die Transistoren konfiguriert sind, um asymmetrisch zu arbeiten, was bedeutet, dass die Drain-Source-Ströme (IDS1, IDS2) der Transistoren im Ein-Zustand unterschiedlich sind, wobei die Ströme durch die Gate-Spannungen (V_{G1}, V_{G2}) der Transistoren (Q1, Q2) gesteuert werden, **dadurch gekennzeichnet, dass** die Ströme durch eine Steuerstufe (2) in unabhängiger Weise gesteuert werden, und die Werte der Spannungen von Betriebsparametern abhängen, wobei der Verstärker einen Speicher (21) beinhaltet, welcher die Wertepaare speichert, welche von diesen Parametern abhängen, wobei der Speicher für die Steuerstufe zugänglich ist.

2. Leistungsverstärker nach Anspruch 1, **dadurch gekennzeichnet, dass** die Werte der Gate-Spannungen (V_{G1}, V_{G2}) von der Frequenz abhängig sind.

3. Leistungsverstärker nach einem der vorhergehenden Ansprüche, **dadurch gekennzeichnet, dass** die Werte der Gate-Spannungen (V_{G1}, V_{G2}) von der Ausgangsleistung des Verstärkers abhängig sind.

4. Leistungsverstärker nach einem der vorhergehenden Ansprüche, **dadurch gekennzeichnet, dass** die Werte der Gate-Spannungen (V_{G1}, V_{G2}) von der Temperatur abhängig sind.

5. Leistungsverstärker nach einem der vorhergehenden Ansprüche, **dadurch gekennzeichnet, dass** die Werte der Gate-Spannungen (V_{G1}, V_{G2}) in einer Kalibrierungsphase bestimmt werden, in welcher die Linearitätskriterien des Verstärkers im Voraus festgelegt sind, und diejenigen Paare gewählt werden, die den Kriterien entsprechen.

6. Leistungsverstärker nach Anspruch 5, **dadurch gekennzeichnet, dass** die Wahrung der Kriterien mithilfe von EVM-Messungen überprüft werden.

7. Leistungsverstärker nach Anspruch 5 oder 6, **dadurch gekennzeichnet, dass** die Wahrung der Kriterien mithilfe von AM/AM- und AM/PM-Messungen überprüft werden.

8. Funkfrequenz-Sende-und Empfangssystem, **dadurch gekennzeichnet, dass** es einen Leistungsverstärker nach einem der vorhergehenden Ansprüche beinhaltet.

9. Funkfrequenz-Sende-und Empfangssystem nach Anspruch 8, **dadurch gekennzeichnet, dass** es tragbar ist.

## Claims

1. A dual transistor RF power amplifier, said transistors (Q1, Q2) being push-pull controlled field effect transistors, said transistors being configured to operate asymmetrically, meaning that the drain-source currents (IDS1, IDS2) of said transistors in the on state are different, said currents being controlled by the gate voltages (V_{G1}, V_{G2}) of said transistors (Q1, Q2), **characterised in that** said currents are independently controlled by a control stage (2) and the values of said voltages are based on operating parameters, said amplifier comprising a memory (21) storing the pairs of said values based on said parameters, the memory being accessible to said control stage.

2. The power amplifier as claimed in claim 1, **characterised in that** the values of said gate voltages (V_{G1}, V_{G2}) are based on the frequency.

3. The power amplifier as claimed in any one of the preceding claims, **characterised in that** the values of said gates voltages (V_{G1}, V_{G2}) are based on the output power of said amplifier.

4. The power amplifier as claimed in any one of the preceding claims, **characterised in that** the values of said gate voltages (V_{G1}, V_{G2}) are based on the temperature.

5. The power amplifier as claimed in any one of the preceding claims, **characterised in that** said values of the gate voltages (V_{G1}, V_{G2}) are determined in a calibration phase, in which, with the linearity criteria of said amplifier being set in advance, the retained pairs are those that meet said criteria.

6. The power amplifier as claimed in claim 5, **characterised in that** compliance with said criteria is verified using EVM measurements.

7. The power amplifier as claimed in claims 5 or 6, **characterised in that** compliance with said criteria is verified using AM/AM and AM/PM measurements.

8. An RF transmission and reception system, **characterised in that** it comprises a power amplifier as claimed in any one of the preceding claims.

9. The RF transmission and reception system as claimed in claim 8, **characterised in that** it is portable.
